# EUROPÄISCHE PATENTANMELDUNG

(11) **EP 0 613 330 A1**
(43) Veröffentlichungstag der Anmeldung: **31.08.1994**
(21) Anmeldenummer: 93117901.4
(22) Anmeldetag: 04.11.1993
(51) Int. Cl.: H05K 3/22, H05K 3/10

(54) **Diskretverdrahtungsverfahren für Leiterplatten und/oder elektronische Baugruppen**

(30) Priorität: 09.11.1992 DE 4237766
(71) Anmelder: SIEMENS AKTIENGESELLSCHAFT, D-80333 München (DE)
(72) Erfinder: Kohler, Gerd, Dipl.-Ing. (TU), D-80639 München (DE)

(57) **Zusammenfassung**

Ein solches Verfahren wird für die Reparatur und/oder die Korrektur einer bereits vorhandenen Verdrahtung der Leiterplatte und/oder der elektronischen Baugruppe benötigt. Gemäß der Erfindung wird die Reparatur- und/oder die Korrekturverdrahtung mittels separaten Auftrages der zu verwendenden Materialien durchgeführt. Dafür werden vorzugsweise die Materialien mittels Dosierköpfen auf die Leiterplatte gebracht. Im Gegensatz zur Anwendung von Drähten lassen sich so vorteilhafterweise auch Mehrlagenverdrahtungen realisieren.

## Beschreibung

Die Erfindung bezieht sich auf ein Diskretverdrahtungsverfahren für Leiterplatten und/oder elektronische Baugruppen, wobei das Verfahren für die Reparatur und/oder die Korrektur einer bereits vorhandenen Verdrahtung der Leiterplatte und/oder der elektronischen Baugruppe vorgesehen ist.

Beispielsweise bei der Herstellung von Leiterplatten, insbesondere von Mehrlagenleiterplatten, ist es notwendig, sogenannte Diskretverdrahtungen für die Reparatur oder die Korrektur einzelner Verdrahtungen der Leiterplatte durchzuführen. Solche Diskretverdrahtungen, bei denen jeweils ein Draht oder aber gegebenenfalls beispielsweise auch zwei aus hochfrequenztechnischen Gründen verdrallte Drähte von einem Startpunkt zu einem Zielpunkt verlegt werden, werden auf der Oberfläche der Leiterplatte durchgeführt. Dazu wird bisher folgendermaßen vorgegangen:

Zunächst wird ein zu verlegender Draht bereitgestellt. Anschließend erfolgt ein Abisolieren und Anlöten des Drahtes am Startkontakt. Der Draht wird dann in vorgegebenen Bahnen auf der Leiterplatte verlegt und an den Umlenkpunkten mit Kleber fixiert. Nunmehr kann ein Abisolieren und Anlöten des Drahtes auf dem Zielkontakt erfolgen. Abschließend wird der überstehende Draht abgeschnitten.

Um letzteres Verfahren automatisiert durchführen zu können, sind komplexe Verdrahtungsautomaten notwendig, was bei der Leiterplattenherstellung zu erheblichen Mehrkosten führt.

Aufgabe der Erfindung ist es demgegenüber, ein Verfahren für eine Reparatur- und/oder Korrekturverdrahtung anzugeben, das automatisierungsfreundlich und mit geringem Aufwand realisierbar ist.

Die Aufgabe ist erfindungsgemäß bei einem Verfahren der eingangs genannten Art dadurch gelöst, daß die Reparatur- und/oder die Korrekturverdrahtung mittels separaten Auftrages der zu verwendenden Materialien durchgeführt wird. Vorzugsweise werden die zu verwendenden Materialien für den Auftrag mittels Dosierköpfe auf die Leiterplatte gebracht.

Mit dem angegebenen Verfahren lassen sich sowohl isolierende als auch leitende Schichten von ausreichender Breite und/oder Dicke auf die Oberfläche der zu verdrahtenden Leiterplatte entsprechend den aus hochfrequenztechnischen Gründen vorgegebenen Bahnen verlegen. Vorteilhaft ist dabei, daß die zum Materialauftrag verwendeten Dosierköpfe die Leiterplatten nicht berühren. Dabei können als Dosierköpfe Düsen verwendet werden, die nach dem Piezoantriebsprinzip arbeiten, was an sich aus der Beschriftungstechnik bekannt ist.

Das angegebene Verfahren ist automatisierungsfreundlich:
Es ist berührungsfrei, wodurch insbesondere Kollisionen der bereits bestückten Leiterplatte mit den Düsen vermieden werden. Dabei können die Düsen und/oder die Leiterplatten programmgesteuert sein, so daß sich beliebige Bahnkoordinaten für die Bewegung vorgeben lassen. Die bis-her bekannten Probleme mit diskreten Drähten, wie beispielsweise Drahtbereitstellung, Drahtabisolieren, Umlenken des Drahtes und Fixieren der Umlenkpunkte, entfallen vollständig. Insgesamt werden mit dem angegebenen Verfahren der maschinelle Aufwand und damit die Kosten für das automatisierte Direktverdrahten von Leiterplatten erheblich gesenkt.

Weitere Einzelheiten und Vorteile der Erfindung ergeben sich aus der nachfolgenden Beschreibung eines Ausführungsbeispieles, wobei das Vorgehen für eine Korrekturverdrahtung einer Leiterplatte entsprechend der Erfindung beschrieben ist.

Es wird von einer fertig bestückten Leiterplatte ausgegangen, bei der eine Korrekturverdrahtung vorgenommen wird. Dazu wird folgendermaßen vorgegangen:

Die zu verdrahtende Leiterplatte wird in eine Aufnahme gelegt und fixiert. Die Bahn vom Startkontakt zum Zielkontakt wird mittels eines Piezodüsenauftrages mit einem auf der Leiterplattenoberfläche haftenden Isolationsmittel besprüht. Dabei werden die Bahnkoordinaten vorteilhafterweise durch die Düsenbewegung erzeugt. Alternativ oder ergänzend kann auch eine Leiterplattenbewegung zur Realisierung der Bahnkoordinaten erfolgen. Als Isolationsmittel wird beispielsweise Polyimid verwendet.

Nach Auftragen aller Isolationsbahnen werden diese polymerisiert, was beispielsweise durch Bestrahlen mit IR (Infrarot)-Licht erfolgen kann. Alternativ kann für den gleichen Zweck auch Heißluft, Laserstrahlung, ein Temperofen oder eine gleichwirkende Energiebeaufschlagung verwendet werden.

Anschließend werden nach einem entsprechenden Verfahren auf die Isolationsbahnen leitende Bahnen aufgespritzt. Als Material für die leitenden Bahnen ist ein Gemisch aus feinstgranuliertem Lot und feinstgranuliertem Kupfer, das in einer Trägerflüssigkeit schwimmt, vorgesehen. Diese leitenden Bahnen werden in entsprechender Weise vom Startkontakt bis zum Zielkontakt durch Einstellen entsprechender Bahnkoordinaten aufgetragen.

Mittels eines der Dosierdüse für das leitende Material nachgeschaltetem Heizstrahls, beispielsweise durch einen IR-Strahler, eine Heißluftdüse, Laser oder einen Hochfrequenzinduktor, wird das Lot unmittelbar umgeschmolzen, wobei die Trägerflüssigkeit verdampft. Alternativ kann auch hier ein Temperofen für das Umschmelzen des Lotes verwendet werden.

Mit den vorstehend beschriebenen Verfahrensschritten wird eine diskrete Leitungsbahn aufgebracht. In weiteren Arbeitsgängen kann über die zuvor aufgetragene leitende Schicht wieder eine Isolationsschicht und anschließend eine weitere Leitungsbahn aufgetragen werden. Insbesondere ist somit eine Mehrlagenverdrahtung möglich.

In Alternative zu dem in einer Trägerflüssigkeit schwimmenden Kupfer/Lotgranulat kann als Material für die Leitungsbahn auch ein Leitkleber oder Leitlack verwendet werden. Damit ergeben sich möglicherweise weitere Vereinfachungen.

Speziell zur Anwendung von Mehrlagenverdrahtungen ist das beschriebene Verfahren vorteilhaft. Nunmehr kann eine DV-technisch gewünschte Verlegung von mehreren Leitungen übereinander realisiert werden. Letzteres war mit Diskret-Drähten problematisch und aufwendig. Auch die bekannten Schwierigkeiten bei Kreuzungen von zwei oder mehreren Drähten sind nunmehr vollständig umgangen.

## Patentansprüche

1. Diskretverdrahtungsverfahren für Leiterplatten und/oder elektronische Baugruppen, wobei das Verfahren für die Reparatur und/oder die Korrektur einer bereits vorhandenen Verdrahtung der Leiterplatte und/oder elektronischen Baugruppe vorgesehen ist, **dadurch gekennzeichnet,** daß die Reparatur- und/oder die Korrekturverdrahtung mittels separaten Auftrages der zu verwendenden Materialien durchgeführt wird.

2. Verfahren nach Anspruch 1 zur Anwendung bei bestückten Leiterplatten, **dadurch gekennzeichnet,** daß die Materialien für das Auftragsverfahren mittels Dosierköpfen auf die Leiterplatte gebracht werden.

3. Verfahren nach Anspruch 2, **dadurch gekennzeichnet,** daß sowohl isolierende als auch leitende Schichten von ausreichender Breite und/oder Dicke auf die Oberfläche der zu verdrahtenden Leiterplatte entsprechend den insbesondere aus hochfrequenztechnischen Gründen vorgegebenen Bahnen verlegt werden.

4. Verfahren nach Anspruch 2, **dadurch gekennzeichnet,** daß die zum Materialauftrag verwendeten Dosierköpfe die Leiterplatte nicht berühren.

5. Verfahren nach Anspruch 4, **dadurch gekennzeichnet,** daß als Dosierköpfe Düsen verwendet werden, die nach dem Piezo-Antriebsprinzip arbeiten.

6. Verfahren nach einem der Ansprüche 2 bis 5, mit folgenden Verfahrensschritten:
a) die zu verdrahtende Leiterplatte wird in eine Aufnahme gelegt und fixiert,
b) die von einem Startkontakt zu einem Zielkontakt vorgegebene Bahn wird mittels eines Düsenauftrages mit einem auf der Leiterplattenoberfläche haftenden Isoliermittel besprüht,
c) nach Auftragen aller Isolationsbahnen werden diese als Schicht polymerisiert,
d) anschließend werden auf die Isolationsschichten Leitungsbahnen aufgespritzt.

7. Verfahren nach Anspruch 6, **dadurch gekennzeichnet,** daß die Bahnkoordinaten bei den Verfahrensschritten b) und d) über eine Düsenbewegung erfolgt.

8. Verfahren nach Anspruch 6, **dadurch gekennzeichnet,** daß die Bahnkoordinaten bei den Verfahrensschritten b) und d) über eine Leiterplattenbewegung erfolgt.

9. Verfahren nach Anspruch 6, **dadurch gekennzeichnet,** daß bei Verfahrensmerkmal c) die Polymerisation der Isolationsbahnen durch Energiestrahlung angeregt und/oder beschleunigt wird.

10. Verfahren nach Anspruch 9, **dadurch gekennzeichnet,** daß die Energiestrahlung IR-Licht, Heißluft, Laserstrahlung oder Wärmestrahlung eines Temperofens ist.

11. Verfahren nach Anspruch 6, **dadurch gekennzeichnet,** daß für das Aufspritzen der Leitungsbahnen ein Gemisch aus granuliertem Lot und granuliertem Kupfer, das in einer Trägerflüssigkeit schwimmt, verwendet wird.

12. Verfahren nach Anspruch 10, **dadurch gekennzeichnet,** daß das Lot mittels Energiestrahlen umgeschmolzen wird und die Trägerflüssigkeit verdampft.

13. Verfahren nach Anspruch 12, **dadurch gekennzeichnet,** daß zum Umschmelzen des Lotes und Verdampfen der Trägerflüssigkeit Infrarot-Licht, Heißluft, Laserstrahlung oder ein Hochfrequenz-Induktor verwendet wird.

14. Verfahren nach Anspruch 6, **dadurch gekennzeichnet,** daß für die Leitungsbahnen ein Leitkleber oder Leitlack, beispielsweise auf Silberpigmentbasis, verwendet wird.

15. Verfahren nach einem der Ansprüche 6 bis 14, **dadurch gekennzeichnet,** daß in zusätzlichen Verfahrensschritten auf die leitende Schicht weitere Isolationsschichten und gegebenenfalls weitere Leitungsbahnen aufgetragen werden.
